(19) Europäisches Patentamt
European Patent Office
Office européen des brevets

(11) **EP 3 327 454 B1**

(12) **EUROPEAN PATENT SPECIFICATION**

(45) Date of publication and mention
of the grant of the patent:
**30.09.2020 Bulletin 2020/40**

(21) Application number: **16200852.8**

(22) Date of filing: **28.11.2016**

(51) Int Cl.:
*G01R 31/36* (2020.01)      *G01R 31/382* (2019.01)
*G01R 31/3835* (2019.01)      *G01R 31/392* (2019.01)
*G01R 31/396* (2019.01)

(54) **BATTERY SYSTEM WITH A SHARED CELL SUPERVISION CIRCUIT UNIT**

BATTERIESYSTEM MIT GEMEINSAM GENUTZTER AUFSICHTSSCHALTUNGSEINHEIT

SYSTÈME DE BATTERIE AVEC CIRCUIT DE SUPERVISION DE CELLULE PARTAGÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.05.2018 Bulletin 2018/22**

(73) Proprietor: **Samsung SDI Co., Ltd.
Giheung-gu
Yongin-si, Gyeonggi-do
17084 (KR)**

(72) Inventors:
• **HOFER, Maximilian
8230 Hartberg (AT)**
• **HAINDL, Michael
8230 Hartberg (AT)**

(74) Representative: **Gulde & Partner
Patent- und Rechtsanwaltskanzlei mbB
Wallstraße 58/59
10179 Berlin (DE)**

(56) References cited:
**EP-A1- 2 244 319**      **DE-A1-102010 040 713**
**US-A1- 2007 285 054**      **US-A1- 2011 196 632**
**US-A1- 2014 232 413**      **US-A1- 2015 241 520**

EP 3 327 454 B1

## Description

## Field of the Invention

The present invention relates to a battery system which comprises a first and a second battery module, comprising at least one battery cell and a first and a second terminal respectively. The battery system further comprises a first bus bar, electrically connecting the first terminal of the first battery module with the terminal of another battery module and/or with a potential of the battery system. Moreover, the battery system comprises a second bus bar, electrically connecting the second terminal of the first battery module with the first terminal of the second battery module. Furthermore, the battery system comprises a Cell Supervision Circuit Unit with a plurality of input channels, wherein the first and second terminal of the first and second battery module are connected to one of the plurality of input channels respectively, the first terminal of the first battery module being connected to a GND-input channel.

## Technological Background

A rechargeable or secondary battery system differs from a primary battery system in that it can be repeatedly charged and discharged, while the latter provides only an irreversible conversion of chemical to electrical energy. Low-capacity rechargeable battery systems are used as power supply for small electronic devices, such as cellular phones, notebook computers and camcorders, while high-capacity rechargeable battery systems are used as the power supply for hybrid vehicles and the like.

Usually, battery systems comprise a plurality of battery modules, wherein the battery modules comprise a plurality of battery cells. The battery cells of a battery module are controlled and supervised with regard to a plurality of different parameters, as for example their respective State of Charge (SoC), temperature and output voltage via so called Cell Supervision Circuit Units (CSC). Such Cell Supervision Circuits or Cell Supervision Circuit Units often are realized as Analog-Front-End (AFE) chips and/or as printed circuit boards (PCB) that are available having 6, 12 or 18 input channels respectively. In the state of the art, one Cell Supervision Circuit Unit is allocated to one battery module respectively.

However, as many different electronic components come to use within a Cell Supervision Circuit Unit (CSC), such an allocation is cost intensive and inefficient regarding the overall power consumption of the battery system.

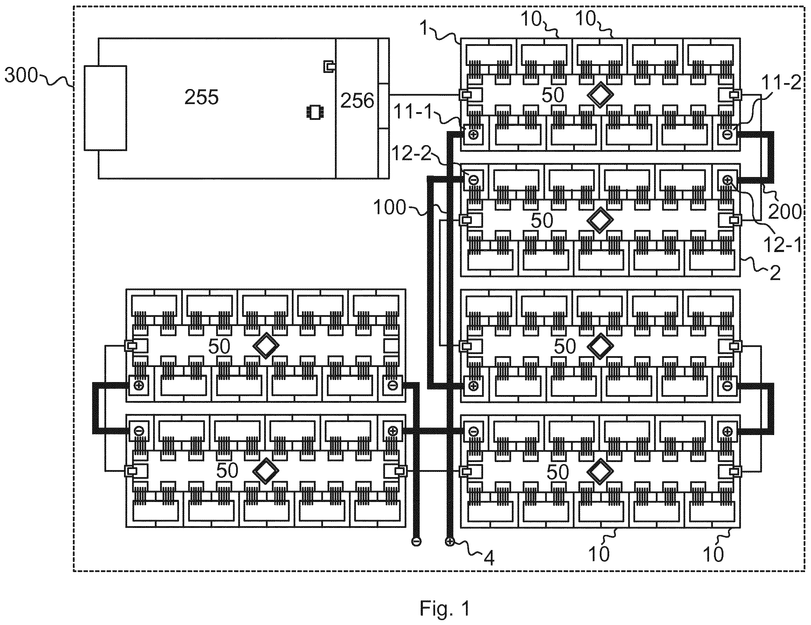

A battery system 300 of the state of the art is shown in figure 1. The battery system 300 comprises six battery modules, each battery module comprising a plurality of battery cells 10 and an own Cell Supervision Circuit Unit 50 respectively. The input channels of the Cell Supervision Circuit Units 50 of the battery modules are electrically connected to the battery cells 10 of the respective corresponding battery module. Furthermore, the battery system 300 shown in figure 1 exemplarily comprises a battery management unit 255 which is connected to the first of the battery modules 1 via a connector 256 of the battery management unit 255. Via a first bus bar 100, the first terminal 11-1 of the first battery module 1 is electrically connected to a predefined potential 4 which in this example is exemplarily equal to the potential of a plus pole of the battery system 300. Furthermore, via a second bus bar 200, the second terminal 11-2 of the first battery module 1 is electrically connected to the first terminal 12-1 of the second battery module 2 of the six battery modules. In this example, the first and the second bus bars 100, 200 are exemplarily realized as metal stripes or bars which are formed to electrically interconnect the aforementioned terminals 11-1, 11-2, 12-1, 12-2.

Via further bus bars, the remaining battery modules are electrically interconnected in series.

EP 2 244 319 A1 discloses a battery module which includes a plurality of battery cells, and includes a voltage bus bar and a voltage/current bus bar that connect electrodes of the plurality of battery cells to one another.

US 2007/0285054 A1 discloses an apparatus and a method for detecting a battery pack voltage, wherein the voltage detection apparatus includes a plurality of selectors for providing a cell voltage of a predetermined cell.

US 2015/0241520 A1 discloses battery monitoring chips which each include a battery monitoring function section that is provided so as to correspond to a respective battery cell group and to monitor a state of each battery cell.

US 2014/0232413 A1 discloses an assembled battery management system that has an assembled battery having a plurality of battery modules connected in series.

US 2011/0196632 A1 discloses a battery pack monitoring apparatus that is for monitoring a battery pack constituted of battery blocks connected in series and each including battery cells connected in series.

DE 10 2010 040 713 A1 discloses a battery system comprising a plurality of battery cells which are grouped into a plurality of series connected battery cell groups.

## Summary of Invention

One or more of the drawbacks of the prior art could be avoided or at least reduced by means of the present invention. In particular, the invention provides a battery system according to claim 1. The battery system comprises a first and a second battery module, comprising at least one battery cell and a first and a second terminal respectively. Furthermore, the battery system comprises a first bus bar, electrically connecting the first terminal of the first battery module with the terminal of another battery module and/or with a potential of the battery system. Moreover, the battery system comprises a second bus bar, electrically connecting the second terminal of the first battery module with the first terminal of the second battery module. The battery system further comprises a Cell Supervision Circuit Unit with a plurality of input channels, wherein the first and second terminal of the first and second battery module are connected to one of the plurality of input channels respectively, the first terminal of the first battery module being connected to a GND-input channel. The Cell Supervision Circuit Unit is adapted to measure the voltage drop across the first bus bar. The battery system further comprises an electronic circuit, adapted to calculate the voltage drop across the second bus bar, using the measured voltage drop across the first bus bar.

With such a battery system, it is possible to allocate one single Cell Supervision Circuit Unit to two or more than two battery modules, as the measurement of the voltage drop across the first bus bar allows for the calculation/estimation of the voltage that drops across the other bus bars of the battery system respectively, thus allowing for one Cell Supervision Circuit Unit to control and supervise the battery cells of multiple different battery modules. The voltage drop across the first bus bar can easily be measured, as the first bus bar is connected to the GND-input channel of the Cell Supervision Circuit Unit. The voltage drop across the other bus bars of the battery system cannot simply be measured, as these bus bars are not on the ground potential of the Cell Supervision Circuit Unit. Therefore, if the Cell Supervision Circuit Unit was used to control and supervise the battery cells also of the second battery module, this control/supervision would be performed erroneously, as the voltage drop across the second bus bar would not be considered by the Cell Supervision Circuit Unit. It is not possible to simply measure the voltages that drop across the second bus bar with one separate channel of the Cell Supervision Circuit Unit, as it is not possible to measure negative voltages with the same. However, when the voltage drop across the second and the further bus bars of a battery system is calculated, the calculated voltages can be taken into account by a Cell Supervision Circuit Unit, thus allowing for the same to control and supervise a plurality of battery modules - and the battery cells thereof - interconnected via bus bars. Expressed in other words, the invention allows for the usage of a shared Cell Supervision Circuit Unit for a plurality of battery modules, interconnected via multiple connectors/bus bars. Furthermore, it is possible to precisely calculate the voltage dropping across the bus bars coming to use within the battery system. This allows for a significant reduction of costs. Furthermore, when compared to an approach that neglects the voltage drop over the bus bars between the battery modules, the accuracy is increased. When compared to an approach in which the voltage drop over the further bus bars is measured with an additional input channel of the Cell Supervision Circuit Unit, there is no risk of a negative voltage being supplied to an input of a battery management system chip which may damage the same through an overvoltage. Thus, the invention allows for the usage of a single Cell Supervision Circuit Unit to supervise/control multiple battery modules of the battery system and thus to significantly decrease the number of Cell Supervision Circuit Units coming to use within the battery system. Therefore, the costs of production and the power consumption of the battery system are significantly decreased and the energy efficiency of the battery system is significantly increased. When the voltage drops across the bus bars are known, the voltages of the different cells of the battery modules can be measured and adjusted accordingly by the Cell Supervision Circuit Unit coming to use.

Preferably, a bus bar is a conductive strip or bar that conducts electricity within a battery system, electrically interconnecting the terminals of battery modules and/or of battery cells and/or of electrical apparatuses and components. Preferably, the bus bar is a conductive metallic strip or bar.

Preferably, the GND-input channel is a ground input channel or an input channel for a ground potential.

Preferably, a Cell Supervision Circuit Unit is equal to a full Cell Supervision Circuit.

Preferably, the potential of the battery system is equal to a ground potential, to the potential of a plus pole or to the potential of a minus pole of the battery system. Furthermore preferred, the potential of the battery system is substantially equal to a ground potential, to the potential of a plus pole or to the potential of a minus pole of the battery system.

Preferably, a terminal of a battery module is formed by a terminal of a battery cell of the respective battery module. Especially preferred, the first terminal of the first battery module is formed by a terminal of a battery cell of the first battery module.

Preferably, the Cell Supervision Circuit Unit is realized as a chip or a chipset. Preferably, the Cell Supervision Circuit Unit has six input channels. Even more preferred, the Cell Supervision Circuit Unit has 12 input channels. In such an embodiment, the maximum number of cells that can be handled by a single Cell Supervision Circuit Unit is 12. Furthermore preferred, the Cell Supervision Circuit Unit has 18 input channels. In many applications - as for example in electric vehicle (EV) applications - the number of serial connected battery cells per battery module is low, which is due to a high number of parallel battery cell connections. Therefore it is possible to use a single Cell Supervision Circuit Unit for more than one battery module.

Preferably, the first terminal of the first battery module is connected to a GND-input channel of the Cell Supervision Circuit Unit.

In a preferred embodiment, the electronic circuit is adapted to calculate the voltage drop across the second bus bar as a function of the measured voltage drop across the first bus bar and of at least one geometrical parameter of the second bus bar. In a series connection of battery modules, the same current flows through every bus bar. Therefore, the voltage drop across a bus bar should substantially be the same for same dimensions - apart from negligible influence of the temperature. If a bus bar is twice as long as the another bus bar - and the other dimensions as width and height of the bus bars are the same - the voltage dropping across this bus bar is also doubled. Due to this reason the voltage drop can be calculated for different lengths of bus bars, when the voltage drop of one bus bar is known. Preferably, the width and height of the first and the second bus bar are identical or substantially identical. Furthermore preferred, the voltage drop across the second bus bar is calculated using the formula:

$$U_{2ndBB} = U_{1stBB} * (l_{2ndBB} / l_{1stBB}),$$

wherein $U_{2ndBB}$ is the calculated voltage drop across the second bus bar, $U_{1stBB}$ is the measured voltage drop across the first bus bar, $l_{2ndBB}$ is the geometrical length of the second bus bar and $l_{1stBB}$ is the geometrical length of the first bus bar.

Preferably, the at least one geometrical parameter is chosen out of a group of parameters, the group of parameters comprising the length of the second bus bar, the width of the second bus bar and the height of the second bus bar. In such an embodiment, the calculation of the voltage drops across the other bus bars can be performed in a highly accurate manner.

In a preferred embodiment, the electronic circuit is adapted to calculate the voltage drop across the second bus bar as a function of the measured voltage drop across the first bus bar and of at least one parameter of the second bus bar. Preferably, the at least one parameter is the material of the second bus bar.

Preferably, the electronic circuit is adapted to consider and/or calculate the inductivity of the bus bar in order to calculate the voltage dropping across the second bus bar. Preferably, the electronic circuit is adapted to consider and/or calculate the inductivity of the second bus bar according to the formula:

$$L = 2* l_{BB} * (ln(l_{BB}/(h+w)) +0,5) nH(cm),$$

wherein L is the inductivity of the second bus bar, $l_{BB}$ is the length of the second bus bar, h is the height of the second bus bar and w is the width of the second bus bar.

Preferably, the electronic circuit is further adapted to consider and/or calculate the ohmic resistance of the second bus bar in order to calculate the voltage dropping across the second bus bar, wherein the cross section, the length and/or the material of the second bus bar is considered.

Preferably, the electronic circuit is adapted to calculate the ohmic resistance R of a bus bar of a predefined material M according to the following formula:

$$R = \rho_M * (l_{BB}/A_{BB}),$$

wherein $\rho_M$ is the specific resistivity of the predefined material and $A_{BB}$ is the cross section of the second bus bar.

Preferably, the first and second bus bars comprise copper. Preferably, the electronic circuit is adapted to calculate the ohmic resistance $R_{CU}$ of a copper bus bar according to the following formula:

$$R_{CU} = \rho_{CU} * (l_{BB}/A_{BB}),$$

wherein $\rho_{CU}$ is the specific resistivity of copper and $A_{BB}$ is the cross section of the second bus bar.

Preferably, the ratio $l_{BB}/R$ is constant for all the bus bars of the battery system.

Preferably, at least one input filter, especially a low-pass filter is used to reduce the measured voltage drop due to the inductance of the bus bar. As can be derived from the aforementioned formulas, the voltage drop across the bus bars is not linearly scalable due to the length of the bus bars respectively. However, with the aforementioned input filters, the linearity of the calculated inductance can be changed/transferred to an insignificant value.

Expressed in other words, when a low pass filter is used, the inductive, not scalable part of the impedance is suppressed to an insignificant value. By using only the scalable ohmic part of the impedance, the voltage drop is linearly scalable and the incorrectly measured cell voltage can be corrected.

In a preferred embodiment, the electronic circuit is integrated within the Cell Supervision Circuit Unit. In such an embodiment, the battery system is even more compact, as the electronic circuit which is allowing for the omittance of a plurality of Cell Supervision Circuit Units is integrated within the one Cell Supervision Circuit Unit that is maintained within the battery system and thus does not require a lot of additional space.

Preferably, the electronic circuit comprises a processing unit. Such a processing unit allows for quick and accurate calculations. Preferably, the processing unit is realized as a microcontroller or a microprocessor.

In a preferred embodiment, the battery system further comprises a level shifter circuit electrically connected to the Cell Supervision Circuit Unit and/or to the first and/or second battery module. In such an embodiment, the level shifter circuit can be used to measure positive and negative voltages, preventing negative voltages from directly being supplied to the input channels of the Cell Supervision Circuit Unit and thus from destroying the Cell Supervision Circuit Unit.

Preferably, the level shifter circuit is a part of the electronic circuit. Furthermore preferred, the level shifter circuit is a part of the Cell Supervision Circuit Unit.

In a preferred embodiment, the level shifter circuit comprises an inverting amplifier, wherein the inverting amplifier comprises an operational amplifier, the operational amplifier comprising an inverting input terminal, a non-inverting input terminal and an output terminal. Such an inverting amplifier with an operational amplifier is reliable, provides for a high gain and has a high input resistance and a low output resistance. Preferably, the value of the sum of the resistances within the feedback circuit of the inverting amplifier is twice as high as the value of the sum of the resistances arranged in series to the inverting input terminal of the inverting amplifier, providing for a gain A of A = -2. Preferably, the value of the sum of the resistances within the feedback circuit of the inverting amplifier is 20k$\Omega$, wherein the value of the sum of the resistances arranged in series to the inverting input terminal of the inverting amplifier is 10k$\Omega$.

Preferably, the output terminal of the operational amplifier is electrically connected to a general purpose input/output terminal of the Cell Supervision Circuit Unit. In such an embodiment, the measurement of the voltage drop across the first bus bar can easily be performed via the Cell Supervision Circuit Unit. Furthermore, embodiments of the invention can be carried out in which only the one single general purpose input/output terminal of the Cell Supervision Circuit Unit (GPIO) is used to measure the voltage drop across the first bus bar, thus allowing for the realization of a compact battery system.

In a preferred embodiment, the inverting input terminal of the operational amplifier is electrically connected to the first bus bar. Preferably, the inverting input terminal of the operational amplifier is electrically connected to a fraction of the first bus bar that is on an end of the first bus bar opposing the fraction of the first bus bar that is in contact with the first terminal of the first battery module. In such an embodiment, the voltage drop across the whole first bus bar is measured.

In a preferred embodiment, the non-inverting input terminal of the operational amplifier is electrically connected to a reference output terminal of the Cell Supervision Circuit Unit. In such an embodiment, the reference output voltage is also provided by the Cell Supervision Circuit Unit and thus does not need to be provided by an external component. This allows for a more compact design of the battery system and enables a precise measurement of the voltage drop across the first bus bar.

Preferably, the reference output terminal of the Cell Supervision Circuit Unit is electrically connected to the first terminal of a switching element, the second terminal of the switching element being electrically connected to the inverting input terminal of the operational amplifier. The switching element is provided for diagnosis purposes in order to reach a predefined Automotive Safety Integrity Level (ASIL). The switching element can for example be switched on a test voltage of 10k/100k*3V=300mV.

In a preferred embodiment, the switching element is a field effect transistor. Such field effect transistors have lower losses than for example bipolar transistors and allow for a quick switching of currents.

Especially preferred, the switching element is a PMOS transistor. PMOS transistors can be realized as highly integrated elements that have small dimensions but nevertheless allow for a reliable switching of currents.

Preferably, the operational amplifier comprises a first and a second power supply input terminal, wherein the first power supply input terminal is electrically connected to the ground potential of the battery system and/or wherein the second power supply input terminal is electrically connected to the Cell Supervision Circuit Unit. In such an embodiment, no further component needs to be provided for the supply of power to the power supply input terminals, allowing for a compact realization of the battery system.

Preferably, an inaccuracy of an offset voltage and of a reference voltage of the operational amplifier is compensated by zerogoing, when a current through the bus bars is equal to zero. When the current through a bus bar is equal to zero, there should also be a voltage drop measurable across the bus bars which is equal to zero. This offset can be calibrated when there is no current drawn out of the battery system.

According to another aspect, a vehicle including a battery system as defined above is provided.

Further aspects of the present invention could be learned from the dependent claims or the following description.

## Brief Description of the Drawings

Features will become apparent to those of ordinary skill in the art by describing in detail exemplary embodiments with reference to the attached drawings in which:

Fig. 1     illustrates a battery system of the state of the art;

Fig. 2     illustrates a battery system according to an embodiment of the invention;

Fig. 3     illustrates a diagram showing the voltage drop across the first bus bar in dependence of the length of the first bus bar, with and without low-pass filtering, and

Fig. 4     illustrates a voltage drop calculated from a measured current by the electronic circuit of the embodiment of a battery system as shown in figure 2.

## Detailed Description of the Invention

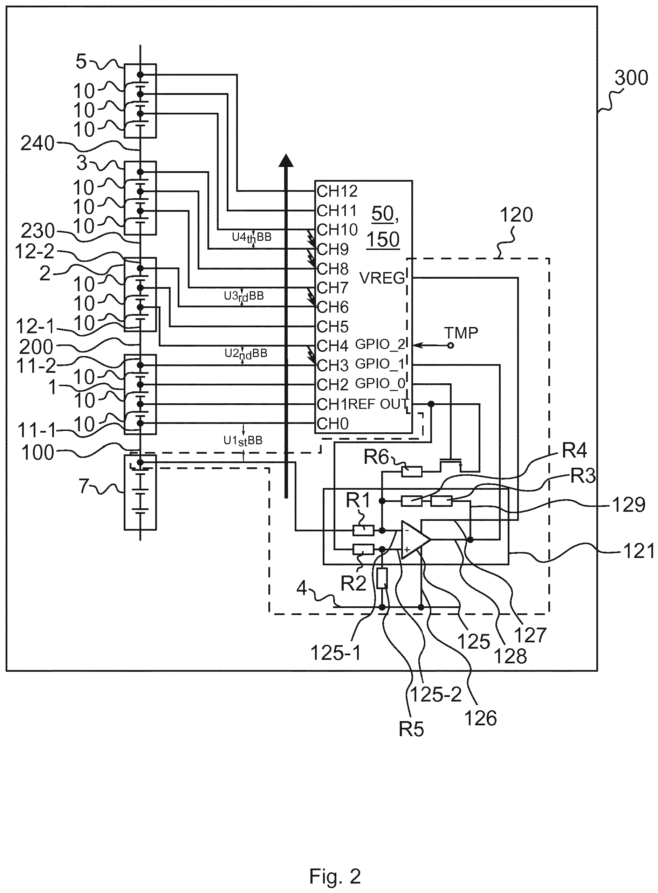

Figure 2 illustrates a first embodiment of a battery system 300 according to the invention. The battery system 300 comprises a plurality of battery modules which are connected in series. In the following, for the sake of a better understanding, the invention will be described mainly referring to a first, a second and a third battery module 1, 2, 3 of the plurality of battery modules. In this embodiment, all battery modules comprise a plurality of battery cells 10, which are exemplarily connected in series. However, in other embodiments, the battery cells 10 of the battery modules can also be connected in parallel or in parallel and in series. Furthermore, each battery module comprises a first and a second terminal respectively. Of the plurality of battery cells 10, only three battery cells 10 per battery module are shown for the sake of a better understanding.

Moreover, the battery system 300 shown in figure 2 comprises a plurality of bus bars, interconnecting the terminals of the battery modules respectively. A first bus bar 100 is electrically connecting the first terminal 11-1 of the first battery module 1 with the terminal of another battery module 7. However, as shown in figure 1, the first bus bar 100 can also be used to connect the first terminal 11-1 of the first battery module 1 with a another potential (not shown) of the battery system 300. Furthermore, the battery system 300 comprises a second bus bar 200, electrically connecting the second terminal 11-2 of the first battery module 1 with the first terminal 12-1 of the second battery module 2. In this embodiment, also the other battery modules are interconnected via bus bars respectively. The battery system 300 further comprises a Cell Supervision Circuit Unit 50 with a plurality of input channels CH0-CH12, wherein the first and second terminal 11-1, 11-2, 12-1, 12-2 of the first and second battery module 1, 2 are connected to one of the plurality of input channels CH0-CH12 respectively, wherein the first terminal 11-1 of the first battery module 1 is electrically connected to a GND-input channel CH0. Furthermore, each terminal of the battery cells 10 of the first and second battery module 1, 2 is electrically connected to an input channel CH0-CH12 of the Cell Supervision Circuit Unit 50.

In this embodiment, the Cell Supervision Circuit Unit 50 exemplarily is realized as a 12-Channel Analog-Frontend (AFE)-Chip which is adapted to measure the voltages at the points of connection to the battery modules. The Cell Supervision Circuit Unit 50 is not adapted to directly measure the voltage dropping across the second bus bar 200 electrically interconnecting the first and the second battery module 1, 2. Also the voltages dropping across the third bus bar 230 electrically interconnecting the second and the third battery module 2, 3 and across the fourth bus bar 240 electrically interconnecting the third and the fourth battery module 3, 5 cannot simply be measured using the Cell Supervision Circuit Unit 50 for the reasons mentioned further above. In figure 2, this is indicated via a lightning symbol in between the respective channels CH3, CH4 and between CH6 and CH7 and between CH 9 and CH10 of the Cell Supervision Circuit Unit 50 respectively. However, the Cell Supervision Circuit Unit 50 is adapted to measure the voltage drop $U_{1stBB}$

across the first bus bar 100, which is performed using a level shifter circuit 120 that is electrically connected to the Cell Supervision Circuit Unit 50 and to the first battery module 1 and which will be described further below.

In this embodiment, the battery system 300 further comprises an electronic circuit 150 adapted to calculate the voltage drop $U_{2ndBB}$ across the second bus bar 200, using the measured voltage drop across the first bus bar 100. Furthermore, in this embodiment, the electronic circuit 150 is also adapted to calculate the voltage drops across the other bus bars 230, 240 of the battery system 300, especially the voltage drops $U_{3rdBB}$, $U_{4thBB}$ across the third and fourth bus bar 230, 240 of the battery system 300. In this embodiment, the aforementioned voltage drops $U_{2ndBB}$, $U_{3rdBB}$, $U_{4thBB}$ are calculated as a function of the measured voltage drop $U_{1stBB}$ across the first bus bar 100 and of the geometrical length $l_{BB}$ of the bus bars 100, 200, 230, 240 respectively, as the width and the height of the bus bars 100, 200, 230, 240 of the battery system 300 in this embodiment are identical. Furthermore, in this embodiment, all bus bars 100, 200, 230, 240 are made of copper. However, in other embodiments, the electronic circuit 150 can also be adapted to calculate the aforementioned voltage drops $U_{2ndBB}$, $U_{3rdBB}$, $U_{4thBB}$, further considering different width, heights or materials of the different bus bars 100, 200, 230, 240. The electronic circuit 150 in this embodiment is integrated within the Cell Supervision Circuit Unit 50. However, it can also be a component that is separate from the Cell Supervision Circuit Unit 50 and/or integrated within another component of the battery system 300, for example within a battery management unit or a battery management system of the battery system 300, or in a separate internal or external processing unit of the battery system 300.

In this embodiment, the electronic circuit 150 is adapted to calculate the voltage dropping across the second bus bar 200 according to the formula:

$$U_{2ndBB} = U_{1stBB} * (l_{2ndBB} / l_{1stBB}),$$

wherein $U_{2ndBB}$ is the calculated voltage drop across the second bus bar 200. $U_{1stBB}$ is the measured voltage drop across the first bus bar 100, $l_{2ndBB}$ is the geometrical length of the second bus bar 200 and $l_{1s1BB}$ is the geometrical length of the first bus bar 100. In this embodiment, the measured voltage drop $U_{1stBB}$ across the first bus bar 100 exemplarily is $U_{1stBB}$ = -13mV, wherein the length of the first bus bar 100 is $l_{1stBB}$ = 135mm. The length of the second bus bar 200 is $l_{2ndBB}$ = 405mm. As all bus bars 100, 200, 230, 240 are made of the same material and have substantially the same width and height, the electronic circuit 150 calculates:

$$U_{2ndBB} = -13mV * (405mm/135mm) = -39mV.$$

Furthermore, the electronic circuit 150 is adapted to calculate the voltage drops $U_{3rdBB}$, $U_{4thBB}$ in the same manner, using the same formula.

As already mentioned, the battery system 300 further comprises a level shifter circuit 120 electrically connected to the Cell Supervision Circuit Unit 50 and to the first battery module 1, 2. The level shifter circuit 120 allows for the measurement of negative voltages and comprises an inverting amplifier 121, wherein the inverting amplifier 121 comprises an operational amplifier 125, the operational amplifier 125 comprising an inverting input terminal 125-1, a non-inverting input terminal 125-2 and an output terminal 128. In this embodiment, the output terminal 128 of the operational amplifier 125 is electrically connected to a general purpose input/output terminal GPIO of the Cell Supervision Circuit Unit 50. The inverting input terminal 125-1 of the operational amplifier 125 is electrically connected to the first bus bar 100, in more detail to a fraction of the first bus bar 100 that is connected to the terminal of the another battery module 7. The general purpose input/output terminal GPIO of the Cell Supervision Circuit Unit 50 the output terminal 128 of the operational amplifier 125 is connected to is adapted to measure the voltage at the output terminal 128 down to a predefined negative boundary, which in this embodiment exemplarily is equal to -1,5V.

A first resistor $R_1$ is connected in series to the inverting input terminal 125-1. The non-inverting input terminal 125-2 of the operational amplifier 125 is electrically connected to a reference output terminal REF_OUT of the Cell Supervision Circuit Unit 50. A second resistor $R_2$ is arranged in the electrical path electrically interconnecting the non-inverting input terminal 125-2 of the operational amplifier 125 with the reference output terminal REF_OUT of the Cell Supervision Circuit Unit 50. The reference output terminal REF_OUT of the Cell Supervision Circuit Unit 50 in this embodiment is adapted to output a reference voltage for the level shifter circuit 120. Moreover, the operational amplifier 125 comprises a feedback circuit, comprising an electrical path 129 that is connected to the output terminal 128 of the operational amplifier 125 and to the inverting input terminal 125-1 of the operational amplifier 125. The electrical path 129 of the feedback circuit comprises a third and fourth resistor $R_3$, $R_4$ connected in series. A fifth resistor $R_5$ is arranged within an electrical path electrically interconnecting the non-inverting input terminal 125-2 of the operational amplifier 125 with the ground potential 4 of the battery system 300. In this embodiment, the resistors $R_1$, $R_2$, $R_3$, $R_4$ and $R_5$ exemplarily have the same value of 10kΩ. However, they also can have any other value respectively and differ from one another. Thus, in another embodiment, $R_1$, $R_2$, $R_3$, $R_4$ and $R_5$ may have different values.

The reference output terminal REF_OUT of the Cell Supervision Circuit Unit 50 in this embodiment is electrically connected to the first terminal of a switching element 60, the second terminal of the switching element 60 being electrically connected to the inverting input terminal 125-1 of the operational amplifier 125. The switching element 60 is exemplarily realized as a PMOS-transistor, however, it also can be realized as any other kind of switching element, for example as another FET, as a bipolar transistor or as another kind of switching means. The Gate-Terminal of the PMOS-transistor in this embodiment exemplarily is electrically connected to another general purpose input/output terminal GPIO of the Cell Supervision Circuit Unit 50, adapted to provide the Gate-Terminal of the PMOS-transistor with a voltage allowing for the transfer of the switching element 60/the PMOS-transistor into a conductive state. In this embodiment, the switching element 60 is connected in series to a further resistor R6 which has a value of exemplarily $R_6 = 100$kΩ. However, the further resistor R6 also can have any other value or be omitted, just as the resistors $R_1$, $R_2$, $R_3$, $R_4$ and $R_5$.

The reference output terminal REF_OUT of the Cell Supervision Circuit Unit 50 in this embodiment is adapted to provide for a reference voltage for the non-inverting input terminal 125-2 of the operational amplifier 125. The reference voltage provided to the non-inverting input terminal 125-2 of the operational amplifier 125 exemplarily has a value of 1,5V. Furthermore, the reference output terminal REF_OUT of the Cell Supervision Circuit Unit 50 in this embodiment is adapted to provide for a test voltage which will be described further hereinafter. Moreover, the operational amplifier 125 comprises a first and a second power supply input terminal 126, 127, wherein the first power supply input terminal 126 is electrically connected to the ground potential 4 of the battery system 300 and wherein the second power supply input terminal 127 is electrically connected to the Cell Supervision Circuit Unit 50, in more detail to a power supply output of the Cell Supervision Circuit Unit 50, denoted VREG, which is adapted to supply the second power supply input terminal 127 with a voltage of in this embodiment exemplarily 5V.

The output voltage Uout at the output terminal 128 of the level shifter circuit 120 in this embodiment can be calculated according to the equation:

$$U_{OUT} = -U_{IN}\frac{R_3 + R_4}{R_1} + U_{REF}\frac{R_5}{R_2 + R_5},$$

wherein $U_{IN}$ is equal to the input voltage at the inverting input terminal 125-1 of the operational amplifier 125 and wherein $U_{REF}$ is the reference voltage provided to the non-inverting input terminal 125-2 of the operational amplifier 125. The resistors R1 to R5 are equal to the resistors $R_1$, $R_2$, $R_3$, $R_4$ and $R_5$ described further above.

In this equation, the term $U_{REF}\dfrac{R_5}{R_2 + R_5}$ represents the shift voltage $U_{SHIFT}$ of the operational amplifier 125, wherein the gain A of the level shifter circuit 120 in this embodiment exemplarily is equal to

$$A = -\frac{R_3 + R_4}{R_1}.$$

As mentioned before, the resistors $R_1$, $R_3$ and $R_4$ have the same value, causing the gain of the inverting amplifier 121 and of the level shifter circuit 120 to be A = -2. However, the absolute value of this gain decreases due to different aspects. These aspects among others comprise an error caused by an offset of the operational amplifier 125 and the accuracy of the reference voltage provided by the reference output terminal REF_OUT of the Cell Supervision Circuit Unit 50. While the reference voltage directly provided at the reference output terminal REF_OUT of the Cell Supervision Circuit Unit 50 is equal to 2V, the reference voltage $U_{REF}$ finally supplied to the non-inverting input terminal 125-2 is equal to 1.5V.

This means that a negative voltage down to -1.5V can be measured with the level shifter circuit 120. If the voltage $U_{IN}$ at the operational amplifier 125 is below -1.5V, for example $U_{IN}$ = -2V, this voltage cannot be measured anymore by the level shifter circuit 120, causing the operational amplifier 125 to come into saturation. However, even in the case of such a saturation, the Cell Supervision Circuit Unit 50 which in this embodiment is realized as an AFE chip (see above) is not destroyed. The switching element 60 which in this embodiment is realized as a PMOS-transistor is provided for diagnoses purposes. In more detail, in order to reach a required Automotive Safety Integrity Level (ASIL), the PMOS-transistor can be switched on via the another general purpose input/output terminal GPIO of the Cell Supervision Circuit Unit 50, allowing for a diagnoses of the level shifter circuit 120, providing the inverting input terminal 125-1 of the operational amplifier 125 with an additional voltage. In more detail, the PMOS-transistor allows for a test voltage of 10k/100k*3V=300mV to be supplied to the inverting input terminal 125-1 of the operational amplifier 125. In this embodiment, the operational amplifier 125 is chosen to be the TSV631. However, also any other suitable operational amplifier 125 can be used. Moreover, if the accuracy of the resistors $R_1$ to $R_6$ is 0.1%, having a 10ppm temperature coefficient, the presented circuit is sufficient to get the required accuracy of the bus bar measurement.

In figure 2, the arrow indicates an arrangement of input filters and of a balancing circuit which is not shown in figure 2 for the sake of a better understanding. Expressed in other words, a balancing circuit and input filters, which in this embodiment are realized as low pass filters, are arranged in between the input channels CH0 to CH12 of the Cell Supervision Circuit Unit 50 and the battery modules of the battery system. With these input filters, the linearity of the calculated inductance can be changed/transferred to an insignificant value. Thus, when a low pass filter comes to use, the inductive, not scalable part of the impedance is suppressed to an insignificant value. By using only the scalable ohmic part of the impedance the voltage drop is linearly scalable and the incorrectly measured cell voltage can be corrected.

However, depending on those input filters, the voltages of the battery modules and battery cells 10 have to be measured synchronously via the input channels CH0 to CH12 of the Cell Supervision Circuit Unit 50. If the time constant of the aforementioned input filters is high, then a small shift between the measurements does not influence the result.

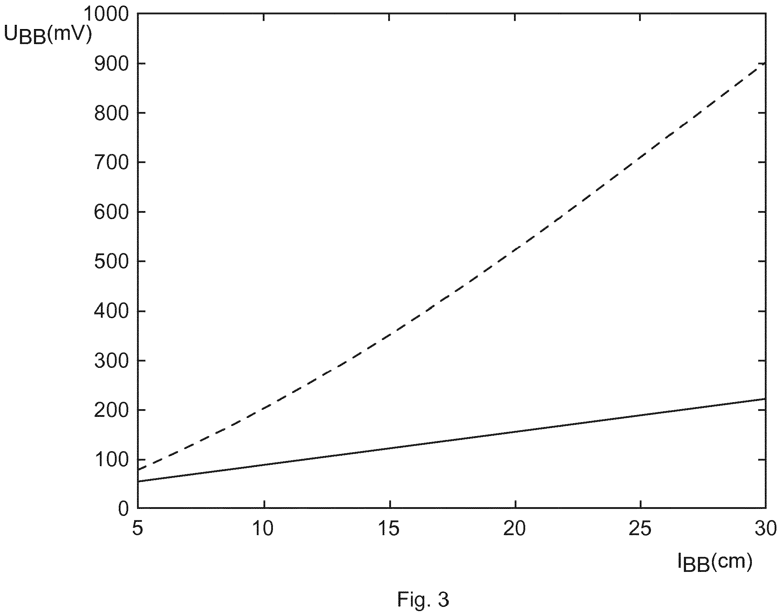

In figure 3, a diagram is shown illustrating the voltage drop across the first bus bar 100 in dependence of the length of the first bus bar 100, with and without low-pass filtering. In more detail, the ordinate of the diagram of figure 3 shows the voltage drop across the first bus bar 100 in mV. The abscissa shows the length of the respective first bus bar 100 in cm. The dotted line in the diagram shows the voltage drop across the first bus bar 100 without that a low-pass-filtering is applied to the measured values. The continuous line in the diagram of figure 3 shows the voltage drop across the first bus bar 100 with a low-pass-filtering that is applied to the measurement. The time constant $\tau$ of the low pass filter used is exemplarily equal to $\tau$ = 2ms. However, any other filter can come to use within a battery system that is according to the invention.

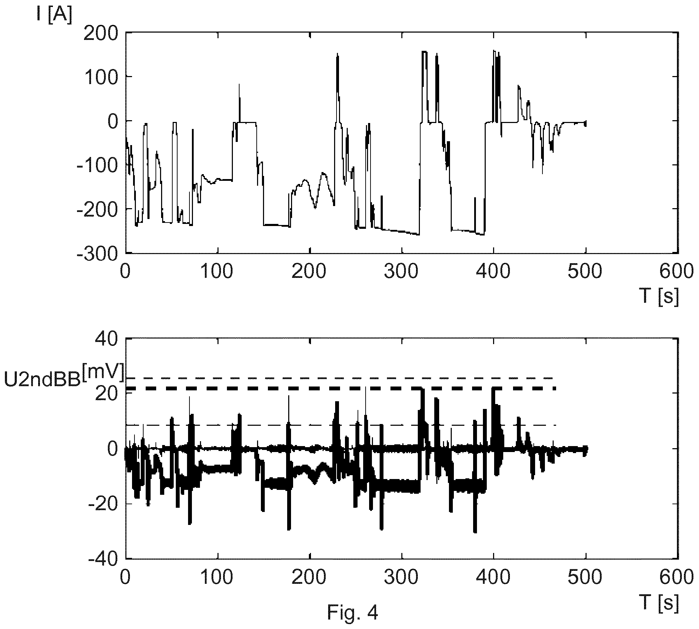

Figure 4 illustrates a voltage drop calculated from a measured current by the electronic circuit 150 of the embodiment of a battery system 300 shown in figure 2. In more detail, figure 4 shows two diagrams. The upper diagram shown in figure 4 illustrates the current in ampere measurable over time in seconds at the output 128 of the operational amplifier 120 of the battery system 300 shown in figure 2. The lower diagram shown in figure 4 illustrates the voltage drop across the second bus bar 200 in mV over time in seconds, using a realistic drive cycle, the voltage drop being calculated/simulated from the aforementioned measured current as shown in the upper diagram.

**Claims**

1. A battery system (300), comprising:

    a first and a second battery module (1, 2), comprising at least one battery cell (10) and a first and a second terminal (11-1, 11-2, 12-1, 12-2) respectively;
    a first bus bar (100), electrically connecting the first terminal (11-1) of the first battery module (1) with the terminal of another battery module (7) and/or with a potential (4) of the battery system (300);
    a second bus bar (200), electrically connecting the second terminal (11-2) of the first battery module (1) with the first terminal (12-1) of the second battery module (2);

a Cell Supervision Circuit Unit (50) with a plurality of input channels (CH0-CH12), and
an electronic circuit (150),
**characterized in that**,
the first and second terminal (11-1, 11-2, 12-1, 12-2) of the first and second battery module (1, 2) are connected to one of the plurality of input channels (CH0-CH12) respectively, the first terminal (11-1) of the first battery module (1) being connected to a GND-input channel (CH0), wherein
the Cell Supervision Circuit Unit (50) is adapted to measure the voltage drop ($U_{1stBB}$) across the first bus bar (100), and the electronic circuit (150) is adapted to calculate the voltage drop (U2ndBB) across the second bus bar (200), using the measured voltage drop across the first bus bar (100).

2. The battery system (300) of claim 1, wherein the electronic circuit (150) is adapted to calculate the voltage drop ($U_{2ndBB}$) across the second bus bar (200) as a function of the measured voltage drop ($U_{1stBB}$) across the first bus bar (100) and of at least one geometrical parameter of the second bus bar (200).

3. The battery system (300) of claim 2, wherein the at least one geometrical parameter is chosen out of a group of parameters, the group of parameters comprising the length (l) of the second bus bar (200), the width (w) of the second bus bar (200) and the height (h) of the second bus bar (200).

4. The battery system (300) of any one of the claims 1 to 3, wherein the electronic circuit (150) is integrated within the Cell Supervision Circuit Unit (50).

5. The battery system (300) of any one of the claims 1 to 4, wherein the electronic circuit (150) comprises a processing unit.

6. The battery system (300) of any one of the previous claims, further comprising a level shifter circuit (120) electrically connected to the Cell Supervision Circuit Unit (50) and/or to the first and/or second battery module (1, 2).

7. The battery system (300) of claim 6, wherein the level shifter circuit (120) comprises an inverting amplifier (121), wherein the inverting amplifier (121) comprises an operational amplifier (125), the operational amplifier (125) comprising an inverting input terminal (125-1), a non-inverting input terminal (125-2) and an output terminal (128).

8. The battery system (300) of claim 7, wherein the output terminal (128) of the operational amplifier (125) is electrically connected to a general purpose input/output terminal (GPIO) of the Cell Supervision Circuit Unit (50).

9. The battery system (300) of claim 7 or 8, wherein the inverting input terminal (125-1) of the operational amplifier (125) is electrically connected to the first bus bar (100).

10. The battery system (300) of one of the claims 7 to 9, wherein the non-inverting input terminal (125-2) of the operational amplifier (125) is electrically connected to a reference output terminal (REF_OUT) of the Cell Supervision Circuit Unit (50).

11. The battery system (300) of one of the claims 7 to 10, wherein the reference output terminal (REF_OUT) of the Cell Supervision Circuit Unit (50) is electrically connected to the first terminal of a switching element (60), the second terminal of the switching element (60) being electrically connected to the inverting input terminal (125-1) of the operational amplifier (125).

12. The battery system (300) of claim 11, wherein the switching element (60) is a field effect transistor.

13. The battery system (300) of claim 12, wherein the switching element (60) is a PMOS transistor.

14. The battery system (300) of one of the claims 7 to 13, wherein the operational amplifier (125) comprises a first and a second power supply input terminal (126, 127), wherein the first power supply input terminal (126) is electrically connected to the ground potential of the battery system (300) and/or wherein the second power supply input terminal (127) is electrically connected to the Cell Supervision Circuit Unit (50).

**Patentansprüche**

1. Ein Batteriesystem (300), aufweisend:

ein erstes und ein zweites Batteriemodul (1, 2), die jeweils zumindest eine Batteriezelle (10) und einen ersten und einen zweiten Anschluss (11-1, 11-2, 12-1, 12-2) aufweisen;
eine erste Sammelschiene (100), die den ersten Anschluss (11-1) des ersten Batteriemoduls (1) mit dem Anschluss eines weiteren Batteriemoduls (7) und/oder mit einem Potential (4) des Batteriesystems (300) elektrisch verbindet;
eine zweite Sammelschiene (200), die den zweiten Anschluss (11-2) des ersten Batteriemoduls (1) mit dem ersten Anschluss (12-1) des zweiten Batteriemoduls (2) elektrisch verbindet;

eine Zellenaufsichtsschaltungseinheit (50) mit einer Vielzahl von Eingangskanälen (CH0-CH12), und

eine elektronische Schaltung (150), **dadurch gekennzeichnet, dass**

der erste und zweite Anschluss (11-1, 11-2, 12-1, 12-2) des ersten und zweiten Batteriemoduls (1, 2) jeweils mit einem der Vielzahl der Eingangskanäle (CH0-CH12) verbunden sind, wobei der erste Anschluss (11-1) des ersten Batteriemoduls (1) mit einem GND-Eingangskanal (CH0) verbunden ist, wobei die Zellenaufsichtsschaltungseinheit (50) angepasst ist, um den Spannungsabfall ($U_{1stBB}$) über die erste Sammelschiene (100) zu messen, und die elektronische Schaltung (150) angepasst ist, um mittels des gemessenen Spannungsabfalls über die erste Sammelschiene (100) den Spannungsabfall (U2ndBB) über die zweite Sammelschiene (200) zu berechnen.

2. Das Batteriesystem (300) nach Anspruch 1, wobei die elektronische Schaltung (150) angepasst ist, um den Spannungsabfall ($U_{2ndBB}$) über die zweite Sammelschiene (200) als Funktion des gemessenen Spannungsabfalls ($U_{1stBB}$) über die erste Sammelschiene (100) und zumindest eines geometrischen Parameters der zweiten Sammelschiene (200) zu berechnen.

3. Das Batteriesystem (300) nach Anspruch 2, wobei der zumindest eine geometrische Parameter aus einer Gruppe von Parametern ausgewählt wird, wobei die Gruppe der Parameter die Länge (l) der zweiten Sammelschiene (200), die Breite (w) der zweiten Sammelschiene (200) und die Höhe (h) der zweiten Sammelschiene (200) aufweist.

4. Das Batteriesystem (300) nach einem der Ansprüche 1 bis 3, wobei die elektronische Schaltung (150) in der Zellenaufsichtsschaltungseinheit (50) integriert ist.

5. Das Batteriesystem (300) nach einem der Ansprüche 1 bis 4, wobei die elektronische Schaltung (150) eine Verarbeitungseinheit aufweist.

6. Das Batteriesystem (300) nach einem der vorhergehenden Ansprüche, ferner aufweisend eine Pegelschieberschaltung (120), die mit der Zellenaufsichtsschaltungseinheit (50) und/oder mit dem ersten und/oder zweiten Batteriemodul (1, 2) elektrisch verbunden ist.

7. Das Batteriesystem (300) nach Anspruch 6, wobei die Pegelschieberschaltung (120) einen invertierenden Verstärker (121) aufweist, wobei der invertierende Verstärker (121) einen Operationsverstärker (125) aufweist, wobei der Operationsverstärker (125) einen invertierenden Eingangsanschluss (125-1), einen nicht-invertierenden Eingangsanschluss (125-2) und einen Ausgangsanschluss (128) aufweist.

8. Das Batteriesystem (300) nach Anspruch 7, wobei der Ausgangsanschluss (128) des Operationsverstärkers (125) mit einem Mehrzweckeingangs- /ausgangsanschluss (GPIO) der Zellenaufsichtsschaltungseinheit (50) elektrisch verbunden ist.

9. Das Batteriesystem (300) nach Anspruch 7 oder 8, wobei der invertierende Eingangsanschluss (125-1) des Operationsverstärkers (125) mit der ersten Sammelschiene (100) elektrisch verbunden ist.

10. Das Batteriesystem (300) nach einem der Ansprüche 7 bis 9, wobei der nicht-invertierende Eingangsanschluss (125-2) des Operationsverstärkers (125) mit einem Referenzausgangsanschluss (REF_OUT) der Zellenaufsichtsschaltungseinheit (50) elektrisch verbunden ist.

11. Das Batteriesystem (300) nach einem der Ansprüche 7 bis 10, wobei der Referenzausgangsanschluss (REF_OUT) der Zellenaufsichtsschaltungseinheit (50) mit dem ersten Anschluss eines Schaltelements (60) elektrisch verbunden ist, wobei der zweite Anschluss des Schaltelements (60) mit dem invertierenden Eingangsanschluss (125-1) des Operationsverstärkers (125) elektrisch verbunden ist.

12. Das Batteriesystem (300) nach Anspruch 11, wobei das Schaltelement (60) ein Feldeffekttransistor ist.

13. Das Batteriesystem (300) nach Anspruch 12, wobei das Schaltelement (60) ein PMOS-Transistor ist.

14. Das Batteriesystem (300) nach einem der Ansprüche 7 bis 13, wobei der Operationsverstärker (125) einen ersten und einen zweiten Energieversorgungseingangsanschluss (126, 127) aufweist, wobei der erste Energieversorgungseingangsanschluss (126) mit dem Massepotential des Batteriesystems (300) elektrisch verbunden ist und/oder wobei der zweite Energieversorgungseingangsanschluss (127) mit der Zellenaufsichtsschaltungseinheit (50) elektrisch verbunden ist.

**Revendications**

1. Système de batterie (300), comprenant :

un premier et un second module de batterie (1, 2), comprenant au moins un élément de batterie (10) et une première et une seconde borne (11-1, 11-2, 12-1, 12-2) respectivement ;
une première barre omnibus (100) reliant électriquement la première borne (11-1) du premier module de batterie (1) à la borne d'un autre module de batterie (7) et/ou à un potentiel (4) du système de batterie (300) ;
une seconde barre omnibus (200) reliant électriquement la seconde borne (11-2) du premier module de batterie (1) à une second borne (12-1) du second module de batterie (2) ;
une unité de circuit de surveillance d'élément (50) avec une pluralité de canaux d'entrée (CH0-CH12), et
un circuit électronique (150),
**caractérisé en ce que**
les première et seconde bornes (11-1, 11-2, 12-1, 12-2) du premier et second module de batterie (1, 2) sont reliées à l'un de la pluralité de canaux d'entrée (CH0-CH12) respectivement, la première borne (11-1) du premier module de batterie (1) étant reliée à un canal d'entrée GND (CH0), où
l'unité de circuit de surveillance d'élément (50) est conçue pour mesurer la chute de tension ($U_{1stBB}$) à travers la première barre omnibus (100), et le circuit électronique (150) est conçu pour calculer la chute de tension ($U_{2ndBB}$) à travers la seconde barre omnibus (200), à l'aide de la chute de tension à travers la première barre omnibus (100).

2. Système de batterie (300) selon la revendication 1, dans lequel le circuit électronique (150) est conçu pour calculer la chute de tension ($U_{2ndBB}$) à travers la seconde barre omnibus (200) en tant que fonction de la chute de tension ($U_{1stBB}$) mesurée à travers la première barre omnibus (100) et d'au moins un paramètre géométrique de la seconde barre omnibus (200) .

3. Système de batterie (300) selon la revendication 2, dans lequel l'au moins un paramètre géométrique est choisi dans un groupe de paramètres, le groupe de paramètres comprenant la longueur (l) de la seconde barre omnibus (200), la largeur (w) de la seconde barre omnibus (200) et la hauteur (h) de la seconde barre omnibus (200).

4. Système de batterie (300) selon l'une quelconque des revendications 1 à 3, dans lequel le circuit électronique (150) est intégré à l'intérieur de l'unité de circuit de surveillance d'élément (50).

5. Système de batterie (300) selon l'une quelconque des revendications 1 à 4, dans lequel le circuit électronique (150) comprend une unité de traitement.

6. Système de batterie (300) selon l'une quelconque des revendications précédentes, comprenant en outre un circuit de décalage de niveau (120) électriquement relié à l'unité de circuit de surveillance d'élément (50) et/ou au premier et/ou second module de batterie (1, 2).

7. Système de batterie (300) selon la revendication 6, dans lequel le circuit de décalage de niveau (120) comprend un amplificateur inverseur (121), où l'amplificateur inverseur (121) comprend un amplificateur opérationnel (125), l'amplificateur opérationnel (125) comprenant une borne d'entrée inverseuse (125-1), une borne d'entrée non inverseuse (125-2) et une borne de sortie (128) .

8. Système de batterie (300) selon la revendication 7, dans lequel le borne de sortie (128) de l'amplificateur opérationnel (125) est électriquement relié à une borne d'entrée-sortie à usage général (GPIO) de l'unité de circuit de surveillance d'élément (50).

9. Système de batterie (300) selon la revendication 7 ou 8, dans lequel la borne d'entrée inverseuse (125-1) de l'amplificateur opérationnel (125) est électriquement reliée à la première barre omnibus (100).

10. Système de batterie (300) selon l'une des revendications 7 à 9, dans lequel la borne d'entrée non inverseuse (125-2) de l'amplificateur opérationnel (125) est électriquement reliée à une borne de sortie de référence (REF_OUT) de l'unité de circuit de surveillance d'élément (50).

11. Système de batterie (300) selon l'une des revendications 7 à 10, dans lequel la borne de sortie de référence (REF_OUT) de l'unité de circuit de surveillance de élément (50) est électriquement reliée à la première borne d'un élément de commutation (60), la seconde borne de l'élément de commutation (60) étant électriquement reliée à la borne d'entrée inverseuse (125-1) de l'amplificateur opérationnel (125).

12. Système de batterie (300) selon la revendication 11, dans lequel l'élément de commutation (60) est un transistor à effet de champ.

13. Système de batterie (300) selon la revendication 12, dans lequel l'élément de commutation (60) est un transistor à canal P.

14. Système de batterie (300) selon l'une des revendications 7 à 13, dans lequel l'amplificateur opérationnel (125) comprend une première et une seconde borne d'entrée d'alimentation en énergie (126, 127), où la première borne d'entrée d'alimentation en énergie (126) est électriquement reliée au potentiel à la masse du système de batterie (300) et/ou où la seconde borne d'entrée d'alimentation en énergie (127) est électriquement reliée à l'unité de circuit de surveillance d'élément (50).

Fig. 1

Fig. 2

Fig. 3

Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2244319 A1
- US 20070285054 A1
- US 20150241520 A1
- US 20140232413 A1
- US 20110196632 A1
- DE 102010040713 A1